**Europäisches Patentamt**

(19) **European Patent Office**

**Office européen des brevets**

(11) Numéro de publication: **0 038 260**
**B1**

(12) **FASCICULE DE BREVET EUROPEEN**

(45) Date de publication du fascicule du brevet:
04.04.84

(51) Int. Cl.³: **H 03 H 2/00**

(21) Numéro de dépôt: 81400576.5

(22) Date de dépôt: 10.04.81

(54) Dispositif à ondes magnétostatiques de volume.

(30) Priorité: 14.04.80 FR 8008279

(73) Titulaire: **THOMSON-CSF, 173, Boulevard Haussmann, F-75379 Paris Cedex 08 (FR)**

(43) Date de publication de la demande:
21.10.81 Bulletin 81/42

(72) Inventeur: **Volluet, Gérard, THOMSON-CSF
SCPI 173, bld Haussmann, F-75360 Paris Cedex 08 (FR)**
Inventeur: **Hartemann, Pierre, THOMSON-CSF
SCPI 173, bld Haussmann, F-75360 Paris Cedex 08 (FR)**

(45) Mention de la délivrance du brevet:
04.04.84 Bulletin 84/14

(74) Mandataire: **Wang, Pierre et al, THOMSON-CSF
SCPI 173, Bld Haussmann, F-75379 Paris Cedex 08 (FR)**

(84) Etats contractants désignés:
**DE GB IT NL SE**

(56) Documents cités:
**FR - A - 2 447 641**
**US - A - 3 866 154**

PROCEEDINGS OF THE IEEE, vol. 64, no. 5, mai 1976
New York, US J. D. ADAM et al.: "Microwave
magnetostatic delay devices based on epitaxial yttrium
iron garnet", pages 794-800
1978 IEEE INTERNATIONAL SYMPOSIUM ON CIRCUITS
AND SYSTEMS PROCEEDINGS ROOSEVELT HOTEL
17-19 mai 1978 New York, US J.D. ADAM et al.:
"Interdigital structures for magnetostatic wave
transversal filters", pages 569-573
THE TRANSACTIONS OF THE INSTITUTE OF
ELECTRONICS AND COMMUNICATION ENGINEERS
OF JAPAN, vol. 61, no. 7, juillet 1978 Tokyo, JP
YASUTAKA SHIMIZU et al.: "Unidirectional

(56) Documents cités: (suite)
surface-acoustic wave transducer by meandering and
interdigital electrodes", pages 557-558
ELECTRONICS, International, vol. 53, no. 11, 8 Mai 1980
New York, US J.D. Adam et al.: "Magnetostatic-wave
devices move microwave design into gigaher tz realm",
pages 123-128

BUNDESDRUCKEREI BERLIN

## Dispositif à ondes magnétostatiques de volume

La présente invention se rapporte aux dispositifs à ondes magnétostatiques de volume. Les ondes magnétostatiques peuvent se propager dans une plaquette de matériau ferrimagnétique soumise à un champ magnétique de polarisation. Ces ondes sont des ondes de surface directives, lorsque le champ magnétique de polarisation est parallèle aux faces principales de la plaquette et lorsque la direction de propagation est normale par rapport à ce champ. La direction de propagation est fixée par l'orientation d'un microruban conducteur amené en contact avec la surface de la plaquette. En faisant circuler un courant alternatif à très haute fréquence dans ce microruban, des ondes magnétostatiques sont excitées. De même, ce microruban peut jouer le rôle de transducteur récepteur, c'est à dire convertir l'énergie des ondes magnétostatiques en énergie électrique. Dans le cas du fonctionnement en ondes magnétostatiques de surface, le microruban se comporte comme un transducteur unidirectionnel de sorte que l'échange d'énergie entre deux microrubans placés en vis à vis peut avoir lieu avec des pertes relativement faibles. Cependant, à une fréquence de 3 GHz, le niveau de saturation en puissance des ondes magnétostatiques de surface est situé 20 dB en dessous du niveau de saturation en puissance des ondes magnétostatiques de volume.

En ce qui concerne les ondes magnétostatiques de volume, l'effet transducteur obtenu au moyen d'un microruban est essentiellement bidirectionnel. Les ondes magnétostatiques de volume sont directives ou contradirectives, selon que le champ magnétique d'excitation est perpendiculaire à la surface de la plaquette ou dirigé selon la direction de propagation. La vitesse de groupe est de même sens que la vitesse de phase, lorsqu'il s'agit d'ondes directives. Ces vitesses sont opposées lorsque les ondes sont contradirectives. Selon la surface de la plaquette, les ondes magnétostatiques de volume directives se propagent de façon quasi isotrope, mais ce n'est le cas ni des ondes magnétostatiques de volume contradirectives, ni des ondes magnétostatiques de surface.

Le fonctionnement bidirectionnel des microrubans servant à émettre et à recevoir les ondes magnétostatiques de volume a pour inconvénient de réduire de 6 dB la puissance électrique susceptible d'être échangée entre deux microrubans. L'énergie rayonnée inutilement peut en outre occasionner des réflexions gênantes qu'il est nécessaire d'atténuer par un traitement approprié des bords de la plaquette.

Il est possible d'associer à un microruban, un coupleur en U pour obtenir un fonctionnement unidirectionnel, mais cette solution entraîne un allongement de la plaquette en matériau ferrimagnétique et peut limiter la bande de fréquences utilisable.

Par ailleurs, il est connu du document US 3,866,154 de réaliser dans le domaine des dispositifs à ondes élastiques de surface des transducteurs à rayonnement unidirectionnel à structure interdigitée qui comportent deux sections rayonnantes à rayonnement bidirectionnel décalées dans l'espace et alimentées par des signaux d'excitation en quadrature de phase.

L'invention a pour objet un dispositif à ondes magnétostatiques de volume comportant à la surface d'une plaquette de matériau ferrimagnétique au moins un transducteur à microruban, caractérisé en ce que ce transducteur comporte une paire d'éléments conducteurs en forme de filament, parallèles et de même longueur, les bornes de ce transducteur étant reliées électriquement d'un même côté aux éléments conducteurs par un circuit polyphasé comportant une jonction hybride à 3 dB; les courants sinusoïdaux circulant le long de ces éléments conducteurs ayant les mêmes distributions d'amplitudes et étant déphasés les uns par rapport aux autres de $\pi/2$, ce déphasage correspondant au déphasage d'une onde magnétostatique de volume franchissant dans le sens de propagation choisi la distance séparant les deux éléments conducteurs; ladite jonction hybride ayant des voies de sortie reliées auxdits éléments conducteurs et deux autres voies dont l'une est terminée par une charge adaptée et dont l'autre est alimentée par un courant sinusoidal.

L'invention sera mieux comprise au moyen de la description et des figures annexées, parmi lesquelles:

La figure 1 est une vue isométrique d'un dispositif transducteur à ondes magnétostatiques de volume de type connu.

La figure 2 est un diagramme explicatif.

Les figures 3 et 4 représentent des dispositifs à ondes magnétostatiques de volume selon l'invention.

La figure 5 représente une jonction hybride à 3 dB.

La figure 6 représente un dispositif à ondes magnétostatiques de volume mettant en oeuvre des transducteurs unidirectionnels et un transducteur bidirectionnel.

La figure 7 représente un oscillateur accordable à ondes magnétostatiques de volume.

Les figures 8, 9 et 10 sont des schémas explicatifs.

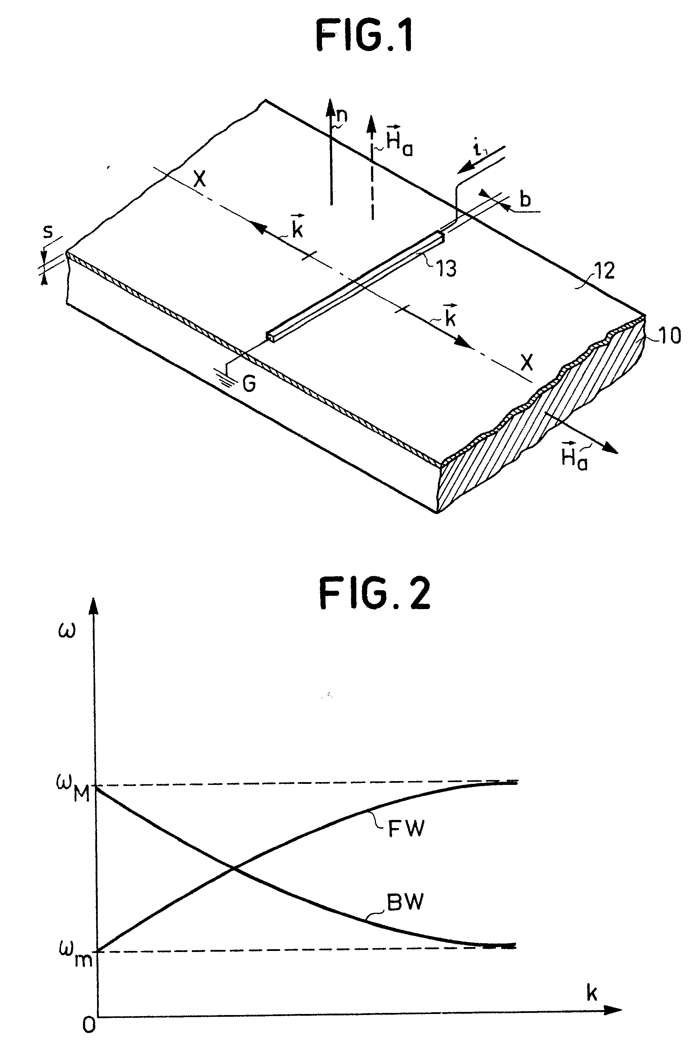

Sur la figure 1, on peut voir un dispositif à ondes magnétostatiques de volume équipé d'un transducteur en forme de microruban 13. Une plaquette de matériau ferrimagnétique est réalisée en déposant par épitaxie sur un substrat 10 de grenat de galodinium et gallium (GGG) une couche 12 de grenat d'yttrium et de fer (YIG) ayant une épaisseur s de quelques dizaines de microns. Ce matéria possède une raie de résonance ferrimagnétique dont la largeur ne dépasse pas une fraction d'Oersted. Il en résulte des pertes de propagation de l'ordre de 38 dB/µs

en bande X ($\Delta H = 0,5$ Oersted). Pour exciter ou recueillir les ondes magnétostatiques de volume, on fait appel au microruban 13 qui se présente sous la forme d'un élément filamentaire conducteur de largeur b. Le microruban 13 peut être constitué par une métallisation de la face supérieure de la couche 12 ou par une métallisation effectuée sur une lamelle diélectrique qui vient coiffer la couche 12. L'une des extrémités du microruban 13 est reliée à la masse G et l'autre extrémité constitue une borne d'entrée. En faisant circuler dans le microruban 13 un courant i à très haute fréquence, des ondes magnétostatiques de volume de nombre d'onde k sont rayonnées selon les deux directions de l'axe de propagation XX. Ces ondes de volume sont du type contradirectif, lorsqu'on applique à la couche 12 le champ magnétique de polarisation $H_a$ représenté en trait plein. Ce champ est orienté suivant l'axe XX et est par conséquent contenu dans le plan de la couche 12. Les ondes magnétostatiques de volume sont directives lorsque le champ magnétique de polarisation $\vec{H_a}$ est orienté suivant la normale n à la couche 12 (flèche en pointillé). Les ondes magnétostatiques de volume directives présentent l'avantage de se propager dans la couche 12 avec une vitesse qui ne dépend pratiquement pas de l'orientation donnée à l'axe XX perpendiculaire au microruban 13.

La figure 2 illustre les propriétés de propagation des ondes magnétostatiques de volume. On a porté en abscisse le nombre d'onde k égal au rapport de la pulsation $\omega$ à la vitesse de phase $v_\psi$ des ondes. Le domaine d'existence des ondes se situe entre les deux lignes pointillées d'ordonnées $\omega_m$ et $\omega_M$. La pulsation minimale $\omega_m$ est définie par la relation suivante:

$$\omega_m = \gamma \cdot H_i \qquad (1)$$

La pulsation maximale est donnée par la relation:

$$\omega_M = \gamma \sqrt{H_i(H_i + 4\pi M)} \qquad (2)$$

où
$\gamma$ est le rapport gyromagnétique égal à 2,8 MHz/Oe dans le cas du YIG
$4\pi M$ est l'aimantation à saturation égale à 1760 Oe dans le cas du YIG
$H_i$ le champ interne, qui diffère du champ de polarisation $H_a$ en raison de l'effet démagnétisant de la couche 12.

La courbe FW se rapporte aux ondes magnétostatiques de volume directives; elle indique l'évolution de la pulsation $\omega$ en fonction du nombre d'onde k pour une valeur donnée du champ $H_a$. La courbe BW indique l'évolution qui caractérise les ondes magnétostatiques de volume contradirectives. La pente des courbes BW et FW donne la valeur de la vitesse de groupe des ondes magnétostatiques de volume; le signe de cette pente justifie la terminologie utilisée »directive« et »contradirevtive« (en anglais »FORWARD« et »BACKWARD«).

Le domaine d'existence des ondes de volume est tel que:

$$\omega_m \leq 2\pi f \leq \omega_M \qquad (3)$$

où f est la fréquence du courant i.

Ce domaine peut être davantage limité par la largeur b du microruban 13. En effet, les ondes magnétostatiques de volume sont excitables jusqu'à une longueur d'onde $\lambda \geq b$.

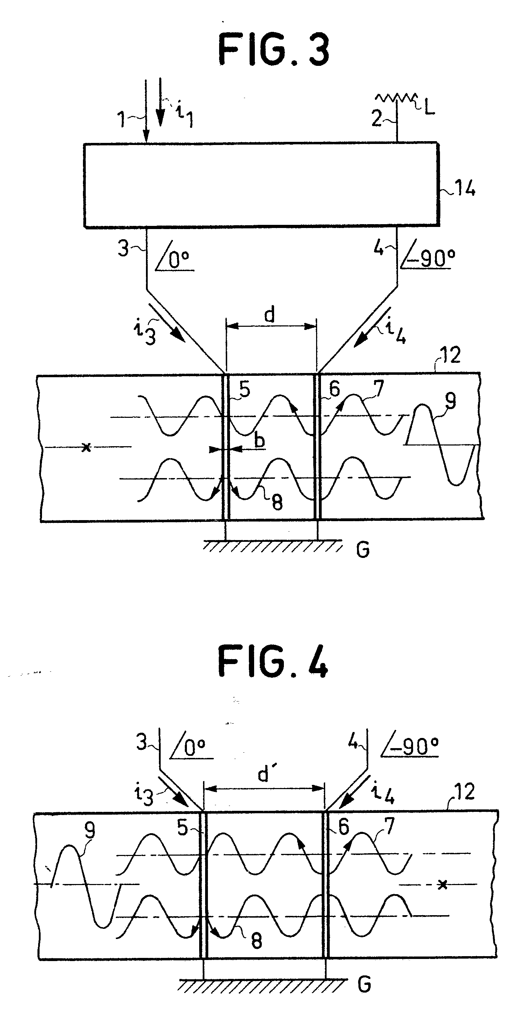

Sur la figure 3, on peut voir un premier exemple de réalisation d'un dispositif à ondes magnétostatiques de volume à rayonnement unidirectionnel. La couche ferrimagnétique 12 porte deux conducteurs filamentaires 5 et 6 écartés d'une distance d. Un transformateur polyphsé 14 à quatre voies 1, 2, 3, 4 est relié par ses voies 3 et 4 aux conducteurs filamentaires 5 et 6. Ce transformateur 14 est dans l'exemple considéré une jonction hybride à 3 dB qui délivre sur ses voies 3 et 4 des courants $i_3$ et $i_4$ en quadrature de phase et d'égales amplitudes. Une charge adaptée L sert de terminaison à la voie 2 afin d'absorber l'énergie qui se présente sur cette voie lorsque les conducteurs 5 et 6 sont désadaptés en impédance par rapport aux impédances propres des voies 3 et 4. L'excitation des ondes magnétostatiques de volume se fait en alimentant la voie 1 où circule le courant $i_1$. Lorsque les conditions d'adaptation sont réalisées, le courant $i_1$ a une amplitude 3 dB supérieure à celle du courant $i_3$ et le courant $i_4$ est par exemple en retard de phase de 90° sur le courant $i_3$. Les courants $i_3$ et $i_4$ circulent dans les conducteurs 5 et 6 et leur retour s'effectue via le plan de masse G.

L'émission d'ondes magnétostatiques de volume par le ruban transducteur 5 est bidirectionnelle suivant un axe perpendiculaire à ce ruban. Les courbes sinusoidales 8 partant du transducteur 5 représentent les fractions d'ondes rayonnées. En ce qui concerne le ruban transducteur 6, les fractions d'ondes rayonnées sont déphasées de −90° de sorte qu'elles sont représentées par des courbes cosinusoidales 7. Bien entendu, tout ceci suppose une excitation sinusoidale de la voie 1. Sur la figure 3, on voit que la distance d est choisie de façon que les deux fractions d'ondes 7 et 8 s'additionnent à droite pour former une onde rayonnée 9, alors qu'elles s'annulent à gauche des rubans 5 et 6. Le rayonnement unidirectionnel de l'ensemble transducteur de la figure 3 est donc obtenu à la condition que:

$$d = n \cdot \lambda_n + \lambda_{n/4} \qquad (4)$$

où $\lambda_n$ est la longueur d'onde des ondes magnétostatiques de volume et n un nombre entier positif ou nul.

La relation (4) peut se mettre sous la forme:

$$\lambda_n = \frac{4d}{4n+1} \qquad (5)$$

Les relations (4) et (5) s'appliquent aussi bien à l'émission vers la droite qu'à la réception des ondes magnétostatiques de volume provenant de la droite. La croix figurant à gauche des rubans 5 et 6 signale le côté inactif de l'ensemble représenté sur la figure 3.

Sur la figure 4, on peut voir une variante de réalisation qui ne diffère de la réalisation de la figure 3 que par l'inversion de sens du rayonnement unidirectionnel. La distance d' séparant les rubans 5 et 6 est donnée par la relation:

$$d' = m\lambda_m + \frac{3}{4}\lambda_m \qquad (6)$$

Elle peut se mettre sous la forme:

$$\lambda_m = \frac{4\,d'}{4\,m+3} \qquad (7)$$

où $\lambda_m$ est la longueur d'onde des ondes magnétostatiques de volume et m un nombre entier positif ou nul.

Si l'on permute les connexions entre la jonction hybride 14 et les ensembles de rubans 5 et 6, on peut définir deux autres configurations possibles. On peut également envisager d'intercaler dans une des liaisons reliant par exemple la voie 4 au ruban 6, un commutateur de phase donnat les déphasages 0 et 180°. Suivant l'état du commutateur, le rayonnement unidirectionnel se produit dans l'un ou l'autre sens.

Lorsque d ou d' est petite, l'unidirectionnalité peut être acquise dans une large bande de fréquence si le transformateur polyphasé 14 permet ce mode de fonctionnement en bande large. Les distances d et d' ne doivent cependant pas être réduites au point de susciter des interactions fortes entre les deux microrubans, car elles pourraient perturber le fonctionnement unidirectionnel de l'ensemble transducteur.

A titre d'exemple non limitatif, on a réalisé une ligne à retard à ondes magnétostatiques de volume directives en formant à la surface d'un substrat en alumine des transducteurs à deux rubans tels que représentés sur les figures 3 et 4. L'autre face du substrat en alumine était complètement métallisée pour jouer le rôle de plan de masse. Les microrubans délimités par photolithographie avaient une largeur b de 35 μm et une longueur de 4 mm. La distance d les séparant était pour chaque ensemble de 200 μm. La distance de propagation était de 6 mm entre les rubans reliés aux voies non déphasées. Deux coupleurs hybrides ont été utilisés, l'un à l'émission, l'autre à la réception. Une couche de grenat d'ittrium fer de 20,5 μm d'épaisseur est formée par hétéroépitaxie en phase liquide sur un substrat de grenat de galodinium et de gallium ayant une épaisseur de 500 μm. La couche épitaxiée est amenée en contact avec la face gravée de la plaquette d'alumine, afin de recouvrier les rubans conducteurs des deux ensembles transducteurs. Les liaisons d'une des deux jonctions hybrides sont permutées, afin d'assurer l'échange des ondes magnétostatiques de volume. Un champ magnétique extérieur est appliqué perpendiculairement à la couche épitaxiée afin de fixer un domaine de fréquence approprié à la propagation des ondes magnétostatiques de volume directives. A une fréquence de 2,12 GHz qui correspond à une longueur d'onde $\lambda_n$ de 800 μm, on a mesuré des pertes d'insertion ne dépassant pas 10 dB (avec n = 0 et en utilisant la relation (5)). Le même dispositif présente une directivité de l'ordre de 30 dB à 2,1 GHz et la bande passante est de 340 MHz à 10 dB. En inversant le sens de l'échange des ondes magnétostatiques de volume, on obtient une perte d'insertion d'environ 14 dB à 2,4 GHz, avec une bande passante similaire.

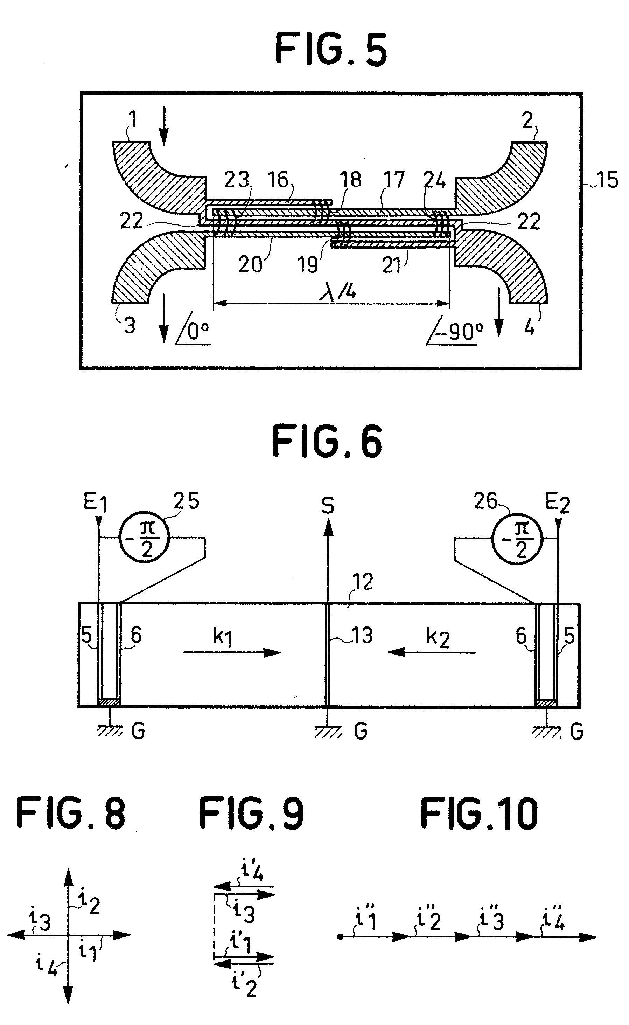

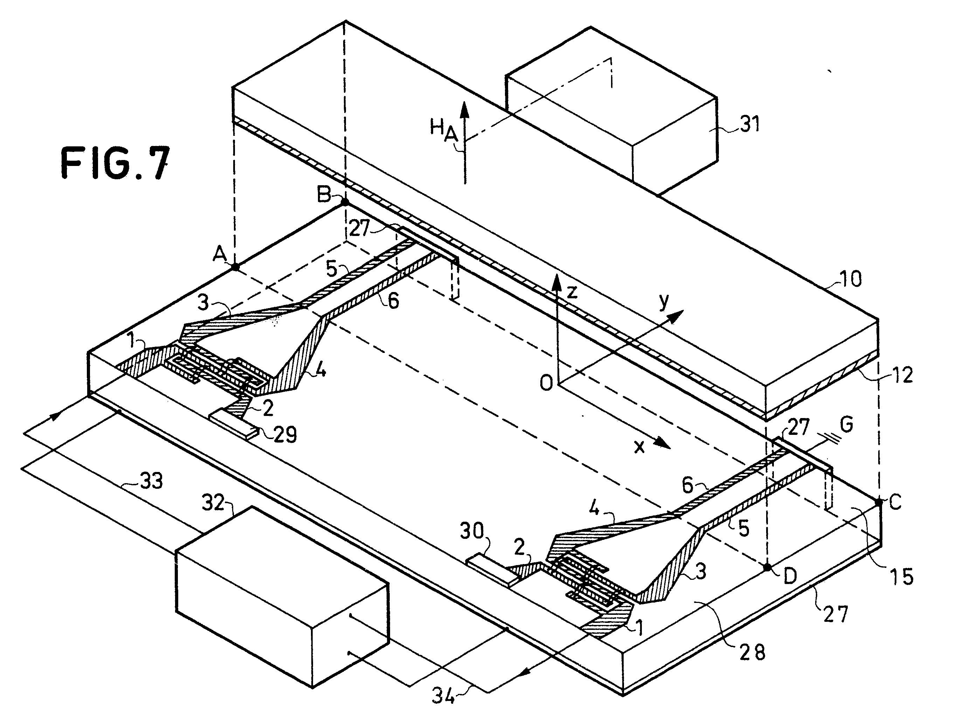

Sur la figure 5, on peut voir un coupleur directionnel à 3 dB particulièrement indiqué pour constituer le transformateur polyphasé 14. Ce coupleur connu sous le nom de coupleur de Lange est réalisé à la surface d'une plaquette diélectrique 15 dont la face dorsale est complètement métallisée. Les métallisations visibles sur la figure 5 comprennent les quatre voies 1, 2, 3 et 4 et un ensemble de microbandes interdigitées qui réalisent sur une distance voisine de $\lambda_{EM}/4$ un couplage serré entre les voies. La voie 1 est reliée à la voie 4 par un conducteur 22 encadré par deux conducteurs 17 et 20 respectivement reliés aux voies 2 et 3. Des conducteurs plus vourts 16 et 21 sont reliés aux voies 1 et 4 pour améliorer le couplage. Des connexions de pontage 18, 19, 23 et 24 parachèvent la structure du coupleur. Ces dernières connexions sont rapportées après photolithograpie par soudage de fils par thermocompression. La longueur d'onde $\lambda_{EM}$ est celles des ondes électromagnétiques transmises par le coupleur.

La figure 6 représente une variante de réalisation d'une ligne à retard mettant en oeuvre un transducteur bidirectionnel 13 encadré par deux transducteurs unidirectionnels selon l'invention. L'ensemble transducteur 5, 6, 25 émet des ondes magnétostatiques de volume de nombre d'onde $k_1$ qui sont captées par le transducteur 13. L'ensemble transducteur 5, 6, 26 émet des ondes magnétostatiques de nombre d'onde $k_2$ vers le transducteur 13. Un échange s'établit entre chacune des entrées $E_1$ et $E_2$ et la sortie commune S. De nombreux dispositifs à ondes magnétostatiques de volume peuvent être déduits des exemples qui précèdent. Parmi ceux-ci, on peut citer les lignes à retard, les filtres, les déphaseurs, les discriminateurs, les lignes dispersives et les oscillateurs accordables.

Une vue isométrique d'un oscillateur accordable est donnée par la figure 7.

Une plaquette d'alumine 15 porte sur l'une de ses faces principales une métallisation 27 jouant le rôle du plan de masse. Cette métallisation comporte deux portions remontantes qui relient à la masse G deux jeux de rubans conducteurs 5,6 disposés dans la zone ABCD de la face supérieure 28 de la plaquette 15. La face supérieure 28 porte en dehors de la zone ABCD deux coupleurs de Lange 1, 2, 3, 4 ayant leurs voies 2 reliées à des charges adaptées 29 et 30. Un circuit amplificateur à microondes 32 est relié par des connexions 33 et 34 aux voies 1 des deux coupleurs de Lange. La zone ABCD est recouverte par une couche de grenat d'yttrium et de fer 12 épitaxiée sur un substrat 10 de grenat de galodonium et de gallium. Pour la clarté du dessin, on a représenté l'ensemble ferrimagnétique écarté de la plaquette 15, mais cet ensemble repose en fait sur la face 28. On est donc en présence d'une ligne à retard à ondes magnétostatiques de volume qui met en oeuvre deux transducteurs unidirectionnels. Cette ligne à retard forme avec le circuit 32 une boucle qui oscille à une fréquence qui est fonction du retard des ondes magnétostatiques se propageant entre les rubans 5 dans la direction OX. L'axe ox appartient à un trièdre trirectangle dont l'axe oz est perpendiculaire à la couche 12 et dont l'axe oy a l'orientation des rubans 5 et 6.

L'accord en fréquence dépend d'un champ magnétique Ha créé dans la couche 12 par des moyens inducteurs 31. Le réglage de l'intensité du champ Ha permet de faire varier la fréquence de fonctionnement de l'oscillateur.

Le rayonnement unidirectionnel peut se généraliser à des transducteurs comportant plus de deux rubans conducteurs équidistants. On peut par exemple exciter un ensemble de quatre rubans conducteurs au moyen de courants tétraphasés $i_1$, $i_2$, $i_3$ et $i_4$ tels que représentés sur la figure 8. Ces courants ont des amplitudes égales et leurs déphasages respectifs forment une progression arithmétique de raison égale à 90°. L'écartement des rubans conducteurs est choisi de telle façon qu'en parcourant cette distance l'onde magnétostatique de volume subisse un déphasage de 90°. Pour l'un des sens de propagation, les ondes magnétostatiques élémentaires peuvent engendrer dans un ruban récepteur des courants $i'_1$, $i'_2$, $i'_3$ et $i'_4$ ayant une résultante nulle comme le montre la figure 9. Pour l'autre sens de propagation, les ondes magnétostatiques élémentaires induisent des courants $i''_1$, $i''_2$, $i''_3$ et $i''_4$ en concordance de phase comme le montre la figure 10. L'unidirectionnalité du rayonnement d'un ensemble de P rubans peut être assurée avec un transformateur polyphsé à P phases. Du point de vue simplicité, c'est le système diphasé qui est le plus avantageux, mais des systèmes plus complexes peuvent offrir des avantages spécifiques de l'application envisagée.

Sans s'écarter du domaine de la présente invention, on peut associer deux transducteurs unidirectionnels rayonnant dans le même sens avec un troisième transducteur utilisé comme récepteur. Cette configuration peut se déduire de la figure 6 en remplaçant le transducteur 13 par un transducteur unidirectionnel. Les deux transducteurs qui se suivent et qui rayonnent dans le même sens sont sécouplés l'un par rapport à l'autre, bien qu'ils soient en mesure d'échanger des ondes magnétostatiques de volume avec le troisième transducteur.

**Revendications**

1. Dispositif à ondes magnétostatiques de volume comportant à la surface d'une plaquette de matériau ferrimagnétique (10, 12) au moins un transducteur à microruban, caractérisé en ce que ce transducteur comporte une paire d'éléments conducteurs en forme de filament parallèles et de même longueur (5, 6); les bornes (1) de ce transducteur étant reliées électriquement d'un même côté aux éléments conducteurs (5, 6) par un circuit polyphasé comportant une jonction hybride à 3 dB (1, 2, 3, 4); les courants sinusoidaux ($i_3$, $i_4$) circulant le long de ces éléments conducteurs (5, 6) ayant les mêmes distributions d'amplitudes et étant déphasés les uns par rapport aux autres de $\pi/2$, ce déphasage correspondant au déphasage d'une onde magnétostatique de volume franchissant dans le sens de propagation choisi (OX) la distance séparant les deux éléments conducteurs; ladite jonction hybride ayant des voies de sortie (3, 4) reliées auxdits éléments conducteurs (5, 6) et deux autres voies dont l'une (2) est terminée par une charge adaptée (L, 29, 30), et dont l'autre (1) est alimentée par uncourant sinusoidal ($i_1$).

2. Dispositif selon la revendication 1, caractérisé en ce que cette jonction hybride est constituée par un coupleur à microbandes interdigitées assurant un couplage électromagnétique serré entre les voies d'entrée et de sortie.

3. Dispositif selon l'une quelconque des revendications 1 et 2, caractérisé en ce que les éléments conducteurs (5, 6) et le circuit polyphasé (1, 2, 3, 4) sont constituées par des métallisations déposées sur l'une des faces principales (28) d'une plaquette (15) de matériau diélectrique; l'autre face principale de la plaquette (15) étant recouverte d'une métallisation (27) jouant le rôle de plan de masse; la plaquette de matériau ferrimagnétique (10, 12) recouvrant une zone (ABCD) de la plaquette diélectrique (15) renferment les éléments conducteurs (5, 6).

4. Dispositif selon l'une quelconque des revendications 1 à 3, caractérisé en ce que la plaquette de matériau ferrimagnétique est une couche de grenat d'yttrium et de fer (12) épitaxiée sur un substrat taillé dans un grenat de gadolinium et de gallium.

5. Dispositif selon l'une quelconque des revendications 1 à 4, caractérisé en ce qu'il comprend au moins deux transducteurs à rayonnement unidirectionnel.

6. Dispositif selon la revendication 5, caractérisé en ce qu'il comprend en outre au moins un transducteur à rayonnement bidirectionnel (13).

7. Dispositif selon l'une quelconque des revendications 1 à 6, caractérisé en ce que la plaquette ferrimagnétique est soumise à un champ magnétique de polarisation (Ha).

8. Dispositif selon la revendication 5, caractérisé en ce qu'il comprend des moyens amplificateurs (32) reliés électriquement aux transducteurs à rayonnement unidirectionnels afin de constituer une boucle oscillatrice.

9. Dispositif selon la revendication 8, caractérisé en ce que des moyens d'accord (31) créent au sein de la plaquette ferrimagnétique (10, 12) un champ magnétique ($H_A$) d'intensité réglable.

## Patentansprüche

1. Vorrichtung für magnetostatische Volumenwellen, mit wenistens einem an der Oberfläche einer Scheibe aus ferrimagnetischem Material (10, 12) angeordneten Wandler aus miniaturisierten Streifen, dadurch gekennzeichnet, daß der Wandler ein erstes Paar von fadenförmigen, parallelen Leiterelementen (5, 6) gleicher Länge umfaßt; wobei die Anschlüsse (1) dieses Wandlers auf derselben Seite elektrisch mit den Leiterelementen (5, 6) durch einen Mehrphasenkreis verbunden sind, der eine 3-dB-Hybridgabel (1, 2, 3, 4) umfaßt; wobei die entlang diesen Leiterelementen (5, 6) fließenden sinusförmigen Ströme ($i_3$, $i_4$) dieselben Amplitudenverteilungen aufweisen und gegeneinander um $\pi/2$ phasenverschoben sind, wobei diese Phasenverschiebung der Phasenverschiebung einer magnetostatischen Volumenwelle entspricht, die in der gewählten Ausbreitungsrichtung (OX) die Entfernung zwischen den beiden Leiterelementen überwindet; wobei die Hybridgabel Ausgangswege (3, 4) aufweist, die mit den Leiterelementen (5, 6) verbunden sind, und zwei weitere Wege aufweist, wovon der eine (2) durch eine angepaßte Belastung ($L_1$, 29, 30) abgeschlossen ist und der andere (1) durch einen sinusförmigen Strom gespeist ist.

2. Vorrichtung nach Anspruch 1, dadurch gekennzeichnet, daß die Hybridgabel aus einem Koppler mit ineinandergreifenden miniaturisierten Streifenleitern gebildet ist, der eine enge elektromagnetische Kopplung zwischen den Eingangs- und Ausgangswegen gewährleistet.

3. Vorrichtung nach Anspruch 1 oder 2, dadurch gekennzeichnet, daß die Leiterelemente (5, 6) und der Mehrphasenkreis (1, 2, 3, 4) durch Metallisierungen gebildet sind, die auf einer der Hauptflächen (28) einer Scheibe (15) aus dielektrischem Material aufgebracht sind; während die andere Hauptfläche der Scheibe (15) mit einer Metallisierung (27) bedeckt ist, welche die Funktion der Masseebene erfüllt; wobei die Scheibe aus ferrimagnetischem Material (10, 12) eine Zone (ABCD) der dielektrischen Scheibe (15) bedeckt, welche die Leiterelemente (5, 6) einschließt.

4. Vorrichtung nach einem der Ansprüche 1 bis 3, dadurch gekennzeichnet, daß die Scheibe aus ferrimagnetischem Material eine Schicht aus Eisen- und Yttrium-Granat (12) ist, die epitaktisch auf einem Substrat gebildet ist, welches aus einem Gadolinium- und Gallium-Granat geschnitten ist.

5. Vorrichtung nach einem der Ansprüche 1 bis 4, dadurch gekennzeichnet, daß sie wenigstens zwei in einer Richtung abstrahlende Wandler umfaßt.

6. Vorrichtung nach Anspruch 5, dadurch gekennzeichnet, daß sie ferner wenigstens einen Wandler (13) umfaßt, der in zwei Richtungen abstrahlt.

7. Vorrichtung nach einem der Ansprüche 1 bis 6, dadurch gekennzeichnet, daß die ferrimagnetische Platte einem magnetischen Polarisationsfeld (Ha) ausgesetzt ist.

8. Vorrichtung nach Anspruch 5, dadurch gekennzeichnet, daß sie Verstärkermittel (32) umfaßt, die elektrisch mit den in eine Richtung abstrahlenden Wandlern verbunden sind, um eine Schwingungsschleife zu bilden.

9. Vorrichtung nach Anspruch 8, dadurch gekennzeichnet, daß Abstimmittel (31) im Inneren der ferrimagnetischen Platte (10, 12) ein magnetisches Feld ($H_A$) einstellbarer Intensität erzeugen.

## Claims

1. Magnetostatic volume wave device comprising at the surface of a wafer of ferrimagnetic material (10, 12) at least one microstrip transducer, characterized in that said transducer comprises a pair of parallel filament-like conductor elements (5, 6) of the same length; the terminals (1) of said transducer are electrically connected on the same side to the conductor elements (5, 6) by a multiphase circuit comprising a 3 dB hybrid junction (1, 2, 3, 4); the sinusoidal currents ($i_3$, $i_4$) flowing along said conductor elements (5, 6) have the same amplitude distributions and are phase-shifted with respect to each other by $\pi/2$, said phase shift corresponding to the phase shift of a magnetostatic volume wave overcoming in the chosen propagation direction (OX) the distance separating the two conductor elements; said hybrid junction has output paths (3, 4) connected to said conductor elements (5, 6) and two other paths, one (2) of which is terminated by an adapted load ($L_1$, 29, 30) and the other (1) of which is fed by a sinusoidal current.

2. Device according to claim 1, characterized in that said hybrid junction is formed by a coupler with interdigitated microstrips ensuring a close electromagnetic coupling between the input and output paths.

3. Device according to any one of claims 1 and 2, characterized in that the conductor elements (5, 6) and the multi-phase circuit (1, 2, 3, 4) are formed by metallizations depostied on one of the major faces (28) of a wafer (15) of dielectric material; the other major face of the wafer (15) is covered with a metallization (27) performing the function of the ground plane; the wafer of ferrimagnetic material (10, 12) covers a zone (ABCD) of the dielectric wafer (15) enclosing the conductor elements (5, 6).

4. Device according to any one of claims 1 to 3, characterized in that the wafer of ferrimagnetic material is a layer of yttrium and iron garnet (12) formed epitaxially on a substrate cut from a gadolinium and gallium garnet.

5. Device according to any one of claims 1 to 4, characterized in that it comprises at least two transducers of unidirectional radiation.

6. Device according to claim 5, characterized in that it further comprises at least one transducer (13) of bidirectional radiation.

7. Device according to any one of claims 1 to 6, characterized in that the ferrimagnetic wafer is subjected to a magnetic polarization field (Ha).

8. Device according to claim 5, characterized in that it comprises amplifying means (32) electrically connected to the transducers of unidirectional radiation in order to form an oscillation loop.

9. Device according to claim 8, characterized in that tuning means (31) produce in the interior of the ferrimagnetic wafer (10, 12) a magnetic field $(H_A)$ of adjustable intensity.

# FIG.1

# FIG.2

# FIG. 3

# FIG. 4

# FIG. 5

1    2

23  16    18  17  24    15

22    22

20    19    21

$\lambda/4$

3    4

$0°$    $-90°$

# FIG. 6

$E_1$    $25$    $S$    $26$    $E_2$

$-\dfrac{\pi}{2}$    $-\dfrac{\pi}{2}$

12

5   6    $k_1$    13    $k_2$    6   5

G    G    G

# FIG. 8    FIG. 9    FIG. 10

$i_2$    $i'_4$    $i''_1$  $i''_2$  $i''_3$  $i''_4$

$i_3$    $i_1$    $i'_3$

$i_4$    $i'_1$

$i'_2$

FIG.7